# EUROPÄISCHE PATENTSCHRIFT

(11) **EP 2 369 742 B1**
(45) Veröffentlichungstag und Bekanntmachung des Hinweises auf die Patenterteilung: **29.08.2012**
(21) Anmeldenummer: 11002142.5
(22) Anmeldetag: 15.03.2011
(51) Int. Cl.: H03F 3/45, H03F 3/08, H03F 1/48

(54) **Verstärkerschaltung und Verfahren zur Konditionierung eines Ausgangsstromsignals eines Detektorelements**
Amplifier circuit and method for conditioning an output current signal of a detecting element
Circuit amplificateur et méthode de conditionnement d'un signal de courant de sortie d'un élément détecteur

(30) Priorität: 23.03.2010 DE 102010012433
(43) Veröffentlichungstag der Anmeldung: 28.09.2011
(73) Patentinhaber: Northrop Grumman LITEF GmbH, 79115 Freiburg (DE)
(72) Erfinder: Rau, Ernst, 79189 Bad Krozingen (DE)
(74) Vertreter: Müller - Hoffmann & Partner

(56) Entgegenhaltungen:
- US-A- 4 639 134
- US-A- 5 023 951
- US-A1- 2003 234 684
- US-A1- 2004 065 876
- US-A1- 2009 163 784

## Beschreibung

Ausführungsformen der Erfindung beziehen sich auf Verstärkerschaltungen, Detektorschaltungen mit Fotodiode sowie Verfahren zur Konditionierung von Ausgangsstromsignalen von Detektorelementen, die einen von einer zu detektierenden physikalischen Größe abhängigen Ausgangsstrom ausgeben.

Eine Reihe von Detektorelementen bzw. Sensoren, z.B. Fotodioden, erzeugen bei Beaufschlagung mit einer vom Detektorelement detektierbaren physikalischen Größe, z.B. Licht, Temperatur, Druck, usw., ein Ausgangsstromsignal, wobei die Ausgangsstromstärke vom Betrag, bzw. Intensität oder Amplitude, der zu detektierenden physikalischen Größe, z.B. Lichtstärke, Temperatur, Druck abhängt. Das Ausgangsstromsignal wird mittels eines Arbeitswiderstands bzw. eines Transimpedanzverstärkers in ein Spannungssignal umgewandelt.

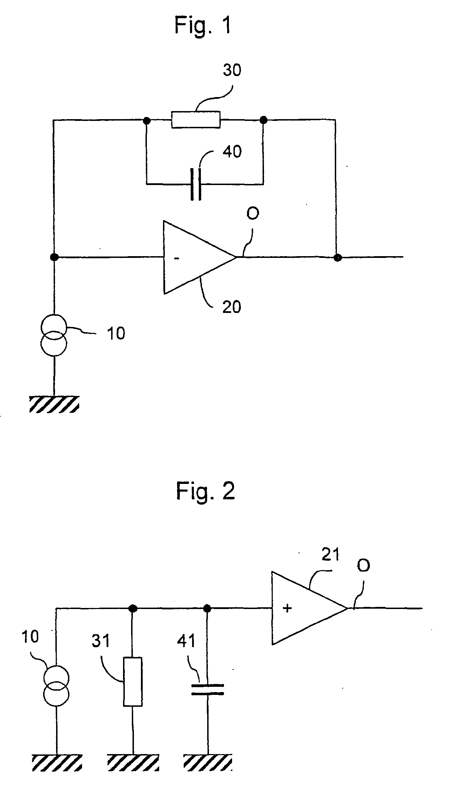

Die Figur 1 zeigt eine Transimpedanzverstärkerschaltung, bei der ein Detektorelement vereinfacht als Stromquelle 10 dargestellt und mit dem invertierenden Eingang eines Operationsverstärkers (OPV) 20 verbunden ist. Der Ausgang O des OPVs 20 ist über einen ohmschen Widerstand 30 mit einer parasitären Kapazität 40 mit dem invertierenden Eingang verbunden.

Die Figur 2 bezieht sich auf eine Verstärkerschaltung zur Umwandlung eines Ausgangsstromsignals eines Detektorelements in ein Spannungssignal mittels eines Arbeitswiderstandes 31. Das Detektorelement ist vereinfacht als Stromquelle 10 dargestellt, die zwischen einem nicht invertierenden Eingang eines OPVs 21 und einem Bezugspotential vorgesehen ist. Der Arbeitswiderstand 31 mit seiner parasitären Kapazität 41 ist ebenfalls zwischen dem nicht invertierenden Eingang und dem Bezugspotential geschaltet, so dass der Ausgangsstrom der Stromquelle 10 durch den Arbeitswiderstand 31 fließt.

Nimmt man an, dass die Verstärkerschaltungen gemäß den Figuren 1 und 2 nur mit Gleichstrom und Gleichspannung, bzw. mit langsam veränderlichen Signalen betrieben werden und legt man ein ideales Verhalten des Operationsverstärkers zugrunde, so ergibt sich der Betrag der Spannung am Ausgang O durch Multiplikation des jeweiligen Ausgangssignalstroms mit dem Arbeitswiderstand. Handelt es sich bei dem Ausgangssignalstrom um ein schnell veränderliches Signal, so zeigt die Verstärkerschaltung aufgrund der parasitären Kapazität des Arbeitswiderstands ein Tiefpassverhalten.

Dieses Tiefpassverhalten kann beispielsweise kompensiert werden, indem im weiteren Signalverlauf ein entsprechender Hochpass vorgesehen wird, wobei das Signalrauschen mitverstärkt wird.

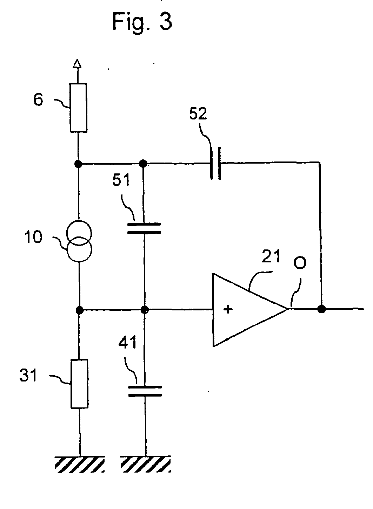

Die Figur 3 bezieht sich auf eine weitere Verstärkerschaltung mit dem Arbeitswiderstand 31 gemäß Figur 2, mit der die parasitäre Kapazität 51 eines Detektorelements mittels einer "Bootstrap"-Schaltung verringert bzw. kompensiert wird. Das Detektorelement ist wieder vereinfacht als Stromquelle 10 dargestellt, deren erster Anschluss über einen Bias-Widerstand 6 an eine Gleichspannungsquelle und deren zweiter Anschluss an einen nicht-invertierenden Eingang eines OPVs 21 gekoppelt ist. Über einen Bootstrap-Kondensator 52 wird ein Ausgangssignal des OPVs 21 auf den nicht-invertierenden Eingang zurückgekoppelt.

Bedingt durch eine Laufzeitverzögerung im OPV21 kommt es zu einer Phasenverschiebung zwischen dem Ausgangs- und Eingangssignal des OPV 21, so dass sich die Kompensationswirkung zu höheren Frequenzen hin verschlechtert.

Aus US 4.639.134 A sind ein Verfahren sowie eine Schaltungsanordnung zum Verstärken eines Eingangsstroms bekannt. Um einen Eingangsstrom an dem Eingang einer Schaltungsanordnung mit einem rückgekoppelten Operationsverstärker zu verstärken, werden zwei quasi gleiche Potentiale in zwei unterschiedlichen Strompfaden mit einem gemeinsamen Summationspunkt aufgebaut. Mit Hilfe der Potentiale wird für jeden Strompfad ein Stromfluss erzeugt. Der Stromfluss in einem der Strompfade wird bestimmt durch den Eingangsstrom und der Strom in dem anderen Strompfad wird durch eine geeignete Auswahl der Impedanzen in den ersten und zweiten Strompfaden bestimmt. Der Strom in dem zweiten Strompfad ist um ein Vielfaches höher als der Strom in dem ersten Strompfad.

Aus US 2009/0163784 A1 ist eine ähnliche Vorrichtung bekannt.

Der Erfindung liegt die Aufgabe zugrunde, eine Verstärkerschaltung mit erweiterter Bandbreite für Detektorelemente, deren Ausgangsstrom signalabhängig ist, zur Verfügung zu stellen. Von der Aufgabe wird ein Verfahren zur Konditionierung eines Ausgangsstromsignals eines Detektorelements umfasst.

Diese Aufgabe wird durch eine Verstärkerschaltung bzw. durch ein Verfahren gemäß den unabhängigen Ansprüchen gelöst. Vorteilhafte Ausgestaltungen ergeben sich aus den jeweiligen Unteransprüchen.

Im Nachfolgenden werden Ausführungsformen der Erfindung anhand der Figuren näher erläutert. Das Hauptaugenmerk liegt auf der Beschreibung und der Verdeutlichung der der Erfindung zugrundeliegenden Prinzipien. Merkmale der unterschiedlichen Ausführungsformen sind miteinander kombinierbar, sofern sie sich einander nicht ausschließen. Im Folgenden wird die Erfindung anhand der Figuren näher erläutert.

Die Figur 1 zeigt ein vereinfachtes Schaltbild einer Transimpedanzverstärkerschaltung gemäß dem Stand der Technik.

Die Figur 2 zeigt ein vereinfachtes Schaltbild einer Verstärkerschaltung mit Arbeitswiderstand gemäß dem Stand der Technik.

Die Figur 3 zeigt ein vereinfachtes Schaltbild einer Verstärkerschaltung mit Bootstrap-Kondensator gemäß dem Stand der Technik.

Die Figur 4 zeigt ein vereinfachtes Schaltbild einer Verstärkerschaltung mit zwei Teilarbeitswiderständen und zwei Kompensationskondensatoren gemäß einer Ausführungsform.

Die Figur 5 zeigt ein vereinfachtes Schaltbild einer Verstärkerschaltung mit zwei Teilarbeitswiderständen und vier Teilkompensationskondensatoren gemäß einer anderen Ausführungsform.

Die Figur 6 zeigt eine Übertragungsfunktion der Verstärkerschaltung gemäß der Figur 3 zur Erläuterung der Wirkung der parasitären Kapazität eines Detektorelementes.

Die Figur 7 zeigt eine Übertragungsfunktion der Verstärkerschaltung gemäß der Figur 2 zur Erläuterung der Wirkung der parasitären Kapazität eines Arbeitswiderstands.

Die Figur 8 zeigt eine Übertragungsfunktion der Verstärkerschaltung gemäß der Figur 5 zur Erläuterung der Wirkung eines Einspeisekondensators gemäß einer Ausführungsform.

Die Figur 9 zeigt eine weitere Übertragungsfunktion für die Verstärkerschaltung gemäß der Figur 5 zur Erläuterung der Wirkung der parasitären Kapazitäten.

Die Figur 10 zeigt ein vereinfachtes Flussdiagramm für ein Verfahren zur Konditionierung eines Ausgangsstromsignals eines Detektorelementes.

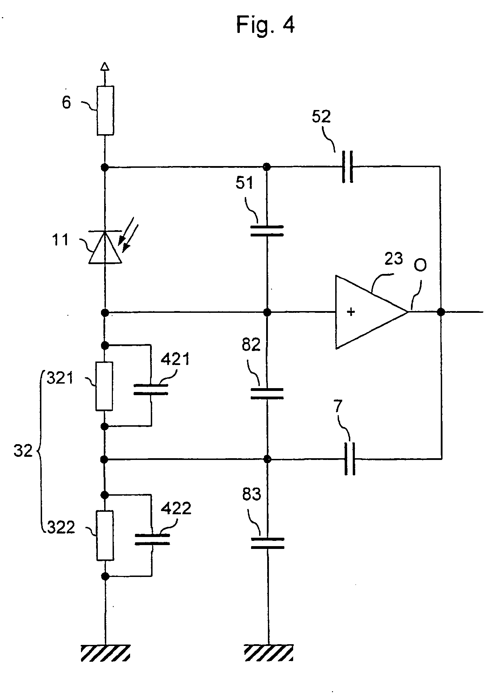

Die Figur 4 zeigt das Schaltbild einer Verstärkerschaltung gemäß einer Ausführungsform mit einem Detektorelement 11, dessen Ausgangsstromsignal in ein Spannungssignal umzuwandeln ist. Gemäß einer Ausführungsform ist das Detektorelement 11 eine Fotodiode, beispielsweise eine PIN-Fotodiode mit niedrigem signalabhängigen Ausgangsstrom, beispielsweise eine PIN-Fotodiode zur Verwendung in einem Interferometer bzw. zur Aufnahme von Interferometersignalen in einem faseroptischen Kreisel. Gemäß anderen Ausführungsformen ist das Detektorelement eine Wechselstromsignalquelle, ein magnetischer Aufnehmer, ein piezoelektrischer Sensor oder ein Thermoelement.

Das Detektorelement 11 kann zum einen über einen Bias-Widerstand 6 mit einer Spannungsquelle verbunden sein. Zum anderen ist das Detektorelement 11 mit dem nicht invertierenden Eingang eines Operationsverstärkers (OPV) 23 sowie mit einem Arbeitswiderstand 32 elektrisch verbunden, der in zwei in Serie geschaltete Teilwiderstände 321, 322 aufgeteilt und an ein Bezugspotential, z.B. Masse, gekoppelt ist. Gemäß anderen Ausführungsformen ist kein Bias-Widerstand 6 vorgesehen.

Eine dem Detektorelement 11 inhärente parasitäre Kapazität ist durch den parallel zum Detektorelement 11 geschalteten Kondensator 51 repräsentiert. In der gleichen Weise repräsentieren die Kondensatoren 421, 422 die den jeweiligen Teilwiderständen 321, 322 inhärenten parasitären Kapazitäten. Parallel geschaltet zu den Teilwiderständen 321, 322 ist jeweils ein Kompensationskondensator 82, 83 zur teilweisen Kompensation von Kapazitätsschwankungen der Kondensatoren 421, 422 vorgesehen. Die Kompensationskondensatoren 82, 83 sind zueinander in Serie zwischen dem nicht invertierenden Eingang des OPV 23 und dem Bezugspotential geschaltet.

Gemäß einer Ausführungsform ist zur Kompensation der parasitären Kapazität 51 des Detektorelements 11 ein Bootstrap-Kondensator 52 vorgesehen, über den ein Ausgangssignal vom Ausgang O des OPV 23 auf den nicht invertierenden Eingang zurückgekoppelt wird. Gemäß anderen Ausführungsformen ist kein Bootstrap-Kondensator vorgesehen.

Zur Kompensation der Tiefpass-Wirkung der parasitären Kapazitäten der Teilwiderstände 321, 322 wird das Ausgangssignal vom Ausgang O des OPV 23 über einen Einspeisekondensator 7 in die Reihe der Kompensationskondensatoren 82, 83 eingespeist, beispielsweise zwischen die Kompensationskondensatoren 82, 83.

Wie der Figur 4 zu entnehmen ist, besteht das Ersatzschaltbild eines realen Arbeitswiderstandes aus der Parallelschaltung von Arbeitswiderstand und parasitärem Kondensator. Wird der Arbeitswiderstand in zwei in Reihe geschaltete Teilwiderstände aufgeteilt, so bleibt der absolute Widerstandswert unverändert, während sich die parasitäre Kapazität nahezu halbiert. Das Verfahren lässt sich jedoch nicht beliebig fortsetzen, da dann parasitäre Kondensatoren von Anschlussflächen hinzukommen.

Die Kapazitätswerte der parasitären Kondensatoren sind starken Schwankungen unterworfen, da sie von den Herstellern der Widerstände üblicherweise nicht spezifiziert werden. Daher wird ein bezüglich seiner Kapazität eng spezifizierter Kompensationskondensator parallel zum Arbeitswiderstand bzw. jeweils parallel zu den beiden Teilwiderständen angeordnet. Die Kapazität des Kompensationskondensators kann in derselben Größenordnung, bzw. etwas größer als die Kapazität des parasitären Kondensators gewählt werden.

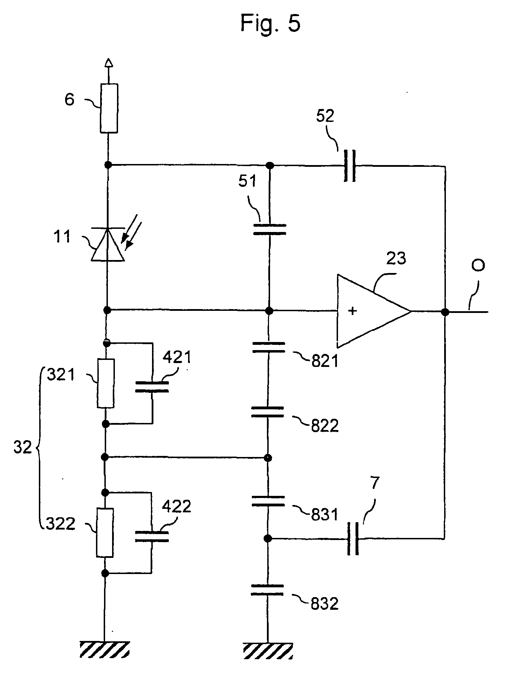

Die Figur 5 zeigt eine Ausführungsform nach der die Kompensationskondensatoren 82, 83 gemäß Figur 4 in jeweils zwei Teilkondensatoren 821, 822, 831, 832 aufgeteilt und die miteinander in Serie geschaltet sind. An einer geeigneten Stelle wird das Ausgangssignal vom Ausgang des OPV 23 über den Einspeisekondensator 7 in die Reihe der Teilkondensatoren 821, 822, 831, 832 eingespeist, zum Beispiel gemäß der Figur 5 zwischen den beiden Teilkondensatoren 831, 832, die dem zum Bezugspotential hin orientierten Teilwiderstand 322 zugeordnet sind. Der Kapazitätswert des Einspeisekondensators ist kleiner 10 pF, z.B. 2 pF oder kleiner, mindestens aber beispielsweise 500 fF.

Gemäß anderen Ausführungsformen mit vier Teilkondensatoren 821, 822, 831, 832 kann der Einspeisekondensator 7 auch an die Verbindung zwischen den Teilkondensatoren 822,831 angeschlossen werden. Zur Festlegung der Anschlußstelle ist neben der Größe der Kondensatoren auch noch das Verhältnis untereinander bestimmend. Da dies zu einer sehr großen Vielfalt führt, sind die Kondensatoren 821,822,831,832 gemäß obigem Beispiel alle gleich gewählt. Der Knoten zwischen den Kondensatoren 831,832 wurde als Optimum für die Einspeisung ermittelt.

Der Arbeitswiderstand 32 kann in der Größenordnung zwischen 100kΩ und 1 MegΩ, die Teilkondensatoren 821,822,831,832 können in der Größenordnung zwischen etwa 0.2pF und 2pF liegen. Der Strom im Arbeitswiderstand kann bei einer Fotodoide zwischen einigen nA und wenigen µA liegen. Bei anderen Sensoren mit höherem Signalstrom ist der Arbeitswiderstand entsprechend anzupassen.

Gemäß anderen Ausführungsformen mit vier Teilkondensatoren 821 , 822, 831, 832 kann das Ausgangssignal zwischen den beiden Teilkondensatoren 821 , 822 eingespeist werden, die dem zum OPV 23 hin orientierten Teilwiderstand 321 zugeordnet sind. Andere Ausführungsformen beziehen sich auf Anordnungen, bei welchen der Arbeitswiderstand 32 in mehr als zwei Teilwiderstände aufgeteilt ist.

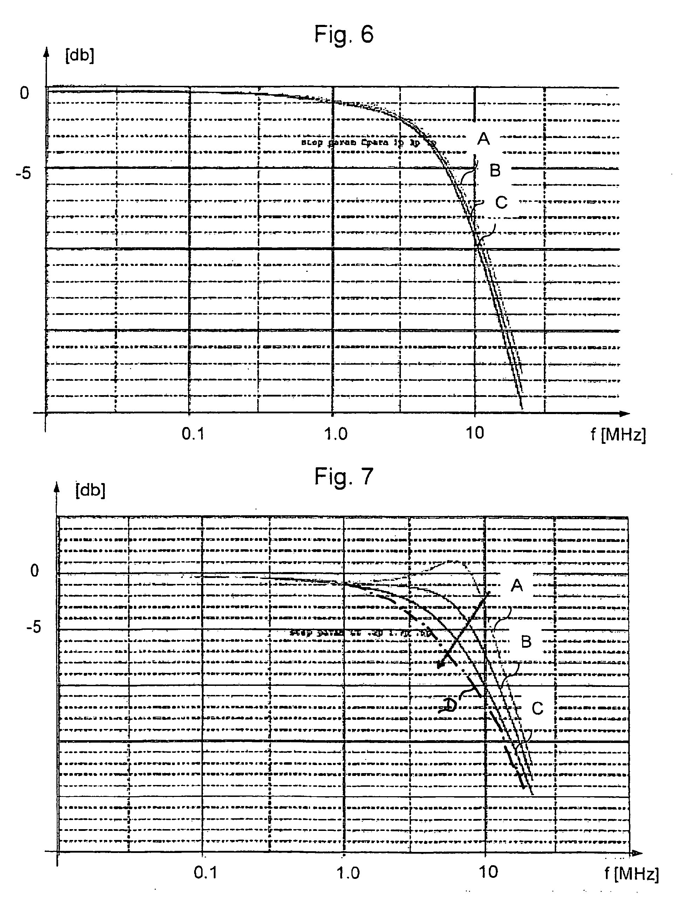

Die Figuren 6 bis 9 zeigen jeweils frequenzabhängige Übertragungsfunktionen der Verstärkerschaltungen gemäß den Figuren 2, 3 und 5. An der Ordinate ist jeweils eine Dämpfung des Ausgangssignals in Dezibel und an der Abszisse die Frequenz in Hertz aufgetragen. Die Übertragungsfunktionen wurden durch Versuche und Simulationen ermittelt.

Die in der Figur 6 dargestellten Übertragungsfunktionen A, B, C zeigen den Einfluss der parasitären Kapazität einer Fotodiode auf die Bandbreite der Verstärkerschaltung mit Bootstrap-Kondensator gemäß der Figur 3. Für die Übertragungsfunktion A wurde eine parasitäre Kapazität von 1 pF, für die Übertragungsfunktion B 2 pF und für die Übertragungsfunktion C 3 pF angenommen. Bei Verwendung eines Bootstrap-Kondensators haben Schwankungen der parasitären Kapazität nur einen geringen Einfluss auf die Bandbreite der Gesamtschaltung. Im gezeigten Beispiel beträgt der Unterschied zwischen Fotodioden mit parasitären Kapazitäten von 1 pF und 3 pF 400 kHz. Eine die Verstärkerschaltung bestimmende Zeitkonstante ist dann der durch den Arbeitswiderstand und die parasitäre Kapazität des Arbeitswiderstandes gegebene Tiefpass.

Die in der Figur 7 dargestellten Übertragungsfunktionen A, B, C, D zeigen den Einfluss der parasitären Kapazität des Arbeitswiderstandes auf die Bandbreite der Verstärkerschaltung. Dabei wurden für die parasitäre Kapazität bei der Kurve A) 0.2pF, B) 0.7pF, C) 1.2pF D) 1.7pF angenommen. Da vier Kondensatoren in Reihe geschaltet sind, weist der kleinste 200/4 = 50fF und der größte 1700/4 ungefähr 400fF auf. Die Bandbreite reicht von 2,7 MHz bei 400 fF bis 10,1 MHz bei 50 fF, unterscheidet sich also ca. um einen Faktor 4.

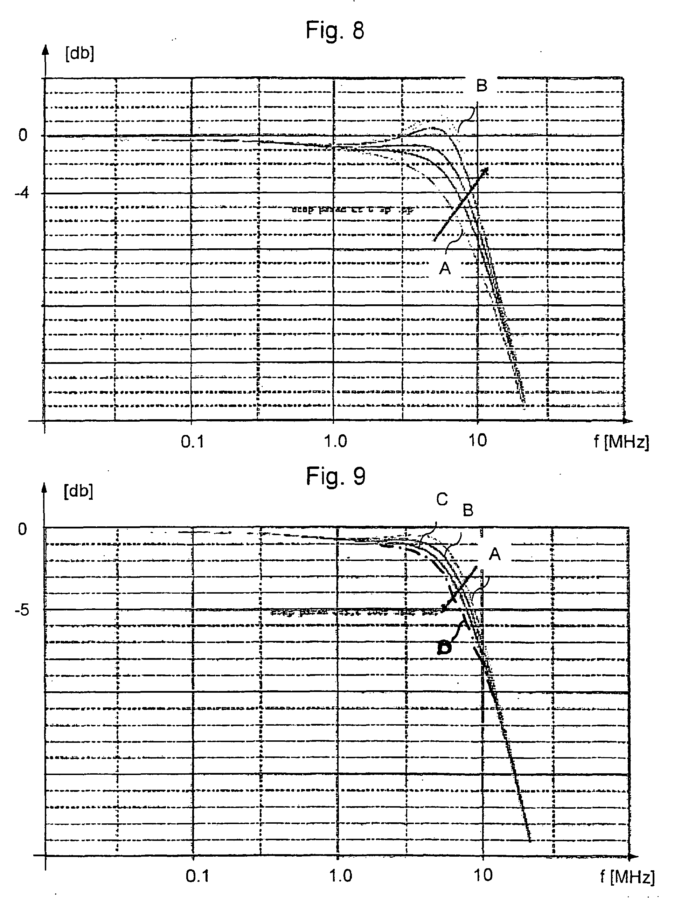

Die Figur 8 zeigt den Einfluss des Einspeisekondensators auf die Bandbreite der Verstärkerschaltung gemäß der Figur 5. Für die Berechnung der Kurve A wurde eine Kapazität des Einspeisekondensators von 0 pF angenommen, für die Kurve B ein Wert von etwa 2 pF. Die Bandbreite beträgt ohne Einspeisekondensator 4,8 MHz und mit einem Einspeisekondensator von 2 pF etwa 8,8 MHz.

Die Figur 9 zeigt den reduzierten Einfluss der parasitären Kondensatoren 421, 422 auf die Bandbreite der Verstärkerschaltung gemäß der Figur 5. Die vier Kurven A, B, C, D wurden mit unterschiedlichen Werten für die Kapazität der parasitären Kondensatoren berechnet: A)100fF, B)150fF, C)200fF, D)250fF. Wie man im Vergleich zur Figur 7 erkennen kann, ist die Abhängigkeit der Bandbreite der Verstärkerschaltung von der Schwankungsbreite der parasitären Kapazitäten der Arbeitswiderstände deutlich geringer.

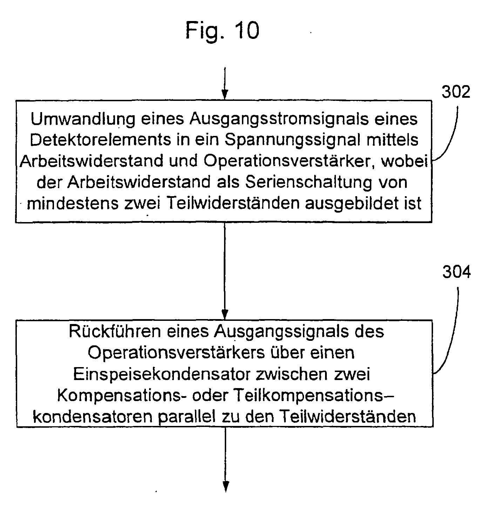

Gemäß dem in der Figur 10 dargestellten Verfahren zur Konditionierung eines Ausgangsstromsignals eines Detektorelements dessen Ausgangsstromsignal signalabhängig ist, wird das Ausgangsstromsignal mittels eines Arbeitswiderstands und eines Operationsverstärkers in ein Spannungssignal umgewandelt (302). Dabei ist der Arbeitswiderstand als Serienschaltung von mindestens zwei Teilwiderständen vorgesehen. Zu den Teilwiderständen ist jeweils ein Kompensationskondensator parallel geschaltet oder sind mehrere zueinander in Serie geschaltete Teilkompensationskondensatoren parallel geschaltet. Das Ausgangssignal des Operationsverstärkers wird über einen Einspeisekondensator zwischen zwei Kompensationskondensatoren oder Teilkompensationskondensatoren zurückgeführt (304), wobei eine Tiefpasswirkung parasitärer Kapazitäten der Teilwiderstände kompensiert wird.

Gemäß einer Ausführungsform wird das Ausgangssignal des Operationsverstärkers zusätzlich über einen Bootstrap-Kondensator und das Detektorelement auf den Eingang des Operationsverstärkers zurückgeführt, wobei eine parasitäre Kapazität des Detektorelements kompensiert wird.

## Patentansprüche

1. Eine Transimpedanzverstärkerschaltung umfassend :
ein Detektorelement (11) zum Delektieren einer physikalischen Größe, mit signalabhängigem Ausgansstrom, einen an ein Bezugspotential gekoppelten Arbeitswiderstand (32) und einen Operationsverstärker (23), wobei ein Anschluss des Detektorelements (11) und der Arbeitswiderstand (32) mit einem nicht-invertierenden Eingang des Operationsverstärkers (23) elektrisch verbunden sind,
der Arbeitswiderstand (32) ist in Form mindestens zweier in Reihe geschalteter Teilwiderstände (321,322) vorgesehen und zu den Teilwiderständen (321, 322) ist jeweils ein Kompensationskondensator (82, 83) parallel geschaltet oder sind mehrere zueinander in Serie geschaltete Teilkompensationskondensatoren (821, 822, 831, 832) parallel geschaltet, und ein Ausgang des Operationsverstärkers (O) ist über einen Einspeisekondensator (7) mit zweien der Kompensationskondensatoren (82, 83, 821, 822, 831, 832) verbunden.

2. Die Verstärkerschaltung nach Anspruch 1, **dadurch gekennzeichnet, dass**
eine Kapazität des jeweiligen Kompensationskondensators (82,83) in einer Größenordnung einer parasitären Kapazität des jeweiligen Teilwiderstandes (321, 322) ist.

3. Die Verstärkerschaltung nach Anspruch 2, **dadurch gekennzeichnet, dass**
die Kapazität des jeweiligen Kompensationskondensators (82,83) größer als die parasitäre Kapazität des jeweiligen Teilwiderstandes (321,322) ist.

4. Die Verstärkerschaltung nach Anspruch 3, **dadurch gekennzeichnet, dass**
jeweils zwei Teilkompensationskondensatoren (821, 822, 831, 832) vorgesehen sind.

5. Die Verstärkerschaltung nach Anspruch 1, **dadurch gekennzeichnet, dass**
der Arbeitswiderstand (32) und das Detektorelement (11) in Serie zu einer Gleichspannungsquelle geschaltet sind.

6. Die Verstärkerschaltung nach einem der Ansprüche 1 bis 5, **dadurch gekennzeichnet, dass**
das Detektorelement (11) eine Wechselstromsignalquelle ist.

7. Die Verstärkerschaltung nach einem der Ansprüche 1 bis 6. **dadurch gekennzeichnet, dass**
das Detektorelement (11) eine Fotodiode ist.

8. Die Verstärkerschaltung nach Anspruch 7, **dadurch gekennzeichnet, dass**
das Detektorelement (11) eine optische PIN-Diode ist.

9. Die Verstärkerschaltung nach einem der Ansprüche 1 bis 8, **dadurch gekennzeichnet, dass**
zum Kompensieren einer parasitären Kapazität (51) des Detektorelements (11) ein Ausgangssignal des Operationsverstärkers (23) über einen Bootstrap-Kondensator (52) und das Detektorelement (11) auf den Eingang des Operationsverstärkers (23) zurückgekoppelt ist.

10. Die Verstärkerschaltung nach einem der Ansprüche 1 bis 8, **dadurch gekennzeichnet, dass**
zwischen einem nicht mit dem Operationsverstärker (23) verbundenen Anschluss des Detektorelements (11) und dem Ausgang des Operationsverstärkers (23) ein Bootstrap-Kondensator (52) vorgesehen ist.

11. Ein Verfahren z Konditionierung eines Ausgangsstromsignals eines Detektorelements (11) zum Delektieren einer physikalischen Größe, wobei das Ausgansstromsignal signalabhängig ist, umfassend :
Umwandlung des Ausgangsstromsignals in ein Spannungssignal mittels eines an ein Bezugspotential angekoppelten Arbeitswiderstands (32) und eines Operationsverstärkers (23), wobei der Arbeitswiderstand (32) als Serienschaltung von mindestens zwei Teilwiderständen (321, 322) vorgesehen ist und zu den Teilwiderständen (321, 322) jeweils ein Kompensationskondensator (82, 83) parallel geschaltet ist oder mehrere zueinander in Serie geschaltete Teilkompensationskondensatoren (821, 822, 831, 832) parallel geschaltet sind, und wobei ein Anschluss des Detektorelements (11) und der Arbeitswiderstand (32) mit einem nicht-invertierenden Eingang des Operationsverstärkers (23) elektrisch verbunden sind;
Rückführen eines Ausgangssignals des Operationsverstärkers (23) über einen Einspeisekondensator (7) zwischen zwei Kompensationskondensatoren (82, 83) oder Teilkompensationskondensatoren (821, 822, 831. 832), wobei eine Tiefpasswirkung parasitärer Kapazitäten der Teilwiderstände (321, 322) kompensiert wird.

12. Das Verfahren nach Anspruch 11, **gekennzeichnet durch**
Rückführen des Ausgangssignals des Operationsverstärkers (23) auf den Eingang des Operationsverstärkers (23) über einen Bootstrap-Kondensator (52) und das Detektorelement (11), wobei eine parasitäre Kapazität (51) des Detektorelements (11) kompensiert wird.

## Claims

1. An amplifier circuit comprising:
a detector element (11) with signal-dependent output current,
a load resistance (32) and an operational amplifier (23), a terminal of the detector element (11) and the load resistance (32) being electrically connected to an input of the operational amplifier (23),
wherein the load resistance (32) is provided in the form of at least two series-connected part-resistors (321, 322) and a compensation capacitor (82, 83) is in each case connected in parallel with the part-resistors (321, 322) or a number of series-connected part-compensation capacitors (821, 822, 831, 832) are connected in parallel with the part-resistors and an output of the operational amplifier (O) is connected to two of the compensation capacitors (82, 83, 821, 822, 831, 832) by a feed capacitor (7).

2. The amplifier circuit as claimed in claim 1, wherein
a capacitance of the respective compensation capacitor (82, 83) is of an order of magnitude of a parasitic capacitance of the respective part-resistor (321, 322).

3. The amplifier circuit as claimed in claim 2, wherein
the capacitance of the respective compensation capacitor (82, 83) is greater than the parasitic capacitance of the respective part-resistor (321, 322).

4. The amplifier circuit as claimed in claim 3, wherein
in each case two part-compensation capacitors (821, 822, 831, 832) are provided.

5. The amplifier circuit as claimed in claim 1, wherein
the load resistance (32) and the detector element (11) are connected in series with a direct-voltage source.

6. The amplifier circuit as claimed in one of claims 1 to 5, wherein
the detector element (11) is an alternating-current signal source.

7. The amplifier circuit as claimed in one of claims 1 to 6, wherein
the detector element (11) is a photodiode.

8. The amplifier circuit as claimed in claim 7, wherein
the detector element (11) is an optical PIN diode.

9. The amplifier circuit as claimed in one of claims 1 to 8, wherein
to compensate for a parasitic capacitance (51) of the detector element (11) an output signal of the operational amplifier (21) is coupled back to the input of the operational amplifier (21) via a bootstrap capacitor (52) and the detector element (11).

10. The amplifier circuit as claimed in one of claims 1 to 8, wherein
a bootstrap capacitor (52) is provided between a terminal of the detector element (11) not connected to the operational amplifier (21) and the output of the operational amplifier (21).

11. A method for conditioning an output current signal of a detector element (11), the output current signal being signal-dependent, comprising:
converting the output current signal into a voltage signal by means of a load resistance (32) and an operational amplifier (21), the load resistance (32) being provided as a series circuit of at least two part-resistors (321, 322) and in each case a compensation capacitor (82, 83) being connected in parallel with the part-resistors (321, 322) or a number of series-connected part-compensation capacitors (821, 822, 831, 832) being connected in parallel with the part-resistors; feeding back an output signal of the operational amplifier (21) via a feed capacitor (7) between two compensation capacitors (82, 83) or part-compensation capacitors (821, 822, 831, 832), compensating for a low-pass effect of parasitic capacitances of the part-resistors (321, 322).

12. The method as claimed in claim 11, comprising feeding back the output signal of the operational amplifier (21) to the input of the operational amplifier (21) via a bootstrap capacitor (52) and the detector element (11), compensating for a parasitic capacitance (51) of the detector element (11).

## Revendications

1. Circuit amplificateur à transimpédance comprenant :
un élément détecteur (11) pour détecter une grandeur physique et doté d'un courant de sortie dépendant d'un signal, une résistance de charge (32) couplée à un potentiel de référence, et un amplificateur opérationnel (23), un raccordement de l'élément détecteur (11) et la résistance de charge (32) étant reliés électriquement à une entrée non inverseuse de l'amplificateur opérationnel (23),
la résistance de charge (32) est prévue sous la forme d'au moins deux résistances partielles (321, 322) montées en ligne, et pour les résistances partielles (321, 322) des condensateurs de compensation respectifs (82, 83) sont montés en parallèle ou plusieurs condensateurs de compensation partiels (821, 822, 831, 832) montés en série entre eux sont montés en parallèle, et une sortie de l'amplificateur opérationnel (O) est reliée par un condensateur d'alimentation (7) à deux condensateurs de compensation (82, 83, 821, 822, 831, 832).

2. Circuit amplificateur selon la revendication 1, **caractérisé en ce qu'**une capacité du condensateur de compensation (82, 83) est de l'ordre d'une capacité parasitaire de la résistance partielle (321, 322).

3. Circuit amplificateur selon la revendication 2, **caractérisé en ce que** la capacité du condensateur de compensation (82, 83) est supérieure à la capacité parasitaire de la résistance partielle (321, 322).

4. Circuit amplificateur selon la revendication 3, **caractérisé en ce qu'**il est prévu deux condensateurs de compensation partiels (821, 822, 831, 832).

5. Circuit amplificateur selon la revendication 1, **caractérisé en ce que** la résistance de charge (32) et l'élément détecteur (11) sont montés en série par rapport à une source de tension continue.

6. Circuit amplificateur selon l'une des revendications 1 à 5, **caractérisé en ce que** l'élément détecteur (11) est une source de signaux à courant alternatif.

7. Circuit amplificateur selon l'une des revendications 1 à 6, **caractérisé en ce que** l'élément détecteur (11) est une photodiode.

8. Circuit amplificateur selon la revendication 7, **caractérisé en ce que** l'élément détecteur (11) est une diode PIN optique.

9. Circuit amplificateur selon l'une des revendications 1 à 8, **caractérisé en ce que** pour compenser une capacité parasitaire (51) de l'élément détecteur (11), un signal de sortie de l'amplificateur opérationnel (23) est relié par rétrocouplage à l'entrée de l'amplificateur opérationnel (23) par un condensateur bootstrap (52) et l'élément détecteur (11).

10. Circuit amplificateur selon l'une des revendications 1 à 8, **caractérisé en ce qu'**il est prévu, entre un raccordement de l'élément détecteur (11) non relié à l'amplificateur opérationnel (23) et la sortie de ce dernier, un condensateur bootstrap (52).

11. Procédé pour conditionner un signal de courant de sortie d'un élément détecteur (11) destiné à détecter une grandeur physique, étant précisé que le signal de courant de sortie est dépendant d'un signal, comprenant la conversion du signal de courant de sortie en un signal de tension à l'aide d'une résistance de charge (32) couplée à un potentiel de référence, et d'un amplificateur opérationnel (23), que la résistance de charge (32) est prévue sous la forme d'un montage en série d'au moins deux résistances partielles (321, 322) et que pour les résistances partielles (321, 322) des condensateurs de compensation respectifs (82, 83) sont montés en parallèle ou plusieurs condensateurs de compensation partiels (821, 822, 831, 832) montés en série entre eux sont montés en parallèle, et qu'un raccordement de l'élément détecteur (11) et la résistance de charge (32) sont reliés électriquement à une entrée non inverseuse de l'amplificateur opérationnel (23) ;
le rétrocouplage d'un signal de sortie de l'amplificateur opérationnel (23) par l'intermédiaire d'un condensateur d'alimentation (7) entre deux condensateurs de compensation (82, 83) ou entre des condensateurs de compensation partiels (821, 822, 831, 832), une action passe-bas de capacités parasitaires des résistances partielles (321, 322) étant compensée.

12. Procédé selon la revendication 11, **caractérisé par** le rétrocouplage du signal de sortie de l'amplificateur opérationnel (23) à l'entrée de celui-ci par l'intermédiaire d'un condensateur bootstrap (52) et de l'élément détecteur (11), une capacité parasitaire (51) de l'élément détecteur (11) étant compensée.
